# EUROPEAN PATENT APPLICATION

(11) **EP 1 675 161 A1**
(43) Date of publication of application: **28.06.2006**
(21) Application number: 05007865.8
(22) Date of filing: 11.04.2005
(51) Int. Cl.: H01L 21/02, H01L 21/316, H01L 21/8246, H01L 27/115, C23C 18/02

(54) **Ferroelectric material, manufacturing method and ferroelectric memory**

(30) Priority: 22.12.2004 JP 2004371905
(71) Applicant: FUJITSU LIMITED, Kawasaki-shi, Kanagawa 211-8588 (JP); TOKYO INSTITUTE OF TECHNOLOGY, Tokyo 152-8550 (JP)
(72) Inventor: Kondo, Masao, Nakahara-ku, Kawasaki-shi, Kanagawa 211 (JP); Maruyama, Kenji, Nakahara-ku, Kawasaki-shi, Kanagawa 211 (JP); Ueno, Risako, Midori-ku, Yokohama, Kanagawa 225-8503 (JP); Funakubo, Hiroshi, Midori-ku, Yokohama, Kanagawa 225-8503 (JP); Uchida, Hiroshi, Nishitokyo-shi, Tokyo 188-0013 (JP); Koda, Seiichiro, Tokyo 157-0065 (JP); Nakaki, Hiroshi, Yokohama-shi, Kanagawa 225-0002 (JP)
(74) Representative: Stebbing, Timothy Charles

(57) **Abstract**

BiFeO₃ precursor solution is coated on the surface of an underlying member (3). Heat treatment is performed after the coating to form a dielectric film (5). The dielectric film is heated in a non-oxidizing atmosphere to crystallize the dielectric film. With this method, a ferroelectric material can be obtained which contains constituent elements of Bi, Fe and O and has crystal lattice of a tetragonal or orthorhombic system. The material can be used to make a lead-free FRAM.

## Description

The present invention relates to a ferroelectric material, a manufacturing method thereof, and ferroelectric memories, and more particularly to those in which the ferroelectric material contains Bi, Fe and O as constituent elements.

Non-volatile memories having a capacitor dielectric film made of ferroelectric material with spontaneous polarization have drawn attention as next generation memories, called FRAM, and applications to non-contact IC cards or the like are expected. One-transistor type FRAM (1T-FRAM) and one-transistor - one-capacitor type FRAM are known, the former having a ferroelectric film deposited on the gate insulating film of FET and the latter having a capacitor dielectric film of DRAM replaced with a ferroelectric film.

Usable known ferroelectric material includes material having a perovskite structure such as Pb(Zr, Ti) O₃ (PZT) and material having a bismuth layer-structured ferroelectric such as (Bi, La)₄Ti₃O₁₂ (BLT) and SrBi₂Ta₂O₉. Since the bismuth layer-structured ferroelectric does not contain lead, contrary to PZT, this material is suitable in terms of environmental contamination. Although BLT has remanent polarization to generally the same degree as PZT, it is difficult to form a capacitor dielectric film with orientation having the maximum remanent polarization in a thickness direction. If a capacitor dielectric film is formed by using BLT, the actual remanent polarization is likely to be smaller than the maximum remanent polarization specific to the material.

In a one-transistor type FRAM, two layers consisting of a gate insulating film and a ferroelectric film are inserted between a channel and a gate electrode. In order to apply a voltage efficiently to a ferroelectric film, it is desired to lower a relative dielectric constant of the ferroelectric film as much as possible. Japanese Patent Laid-open Publication No. 2001-210794 discloses FRAM made of ferroelectric material BiFeO₃ which does not contain lead.

As compared to PZT, however, BiFeO₃ has a small remanent polarization.

It is therefore desirable to provide ferroelectric material which does not contain lead and presents remanent polarization to generally the same degree as PZT, and a method of manufacturing the same.

It is also desirable to provide a ferroelectric memory using such ferroelectric material.

According to one aspect of the present invention, there is provided a ferroelectric material containing constituent elements of Bi, Fe and O and having crystal lattice of a tetragonal or orthorhombic system.

According to another aspect of the present invention, there is provided a ferroelectric material containing constituent elements of Bi, Fe and O and having remanent polarization larger than 6.1 µC/cm².

According to still another aspect of the present invention, there is provided a ferroelectric material containing constituent elements of Bi, Fe and O and having a relative dielectric constant equal to or larger than 100 and equal to or smaller than 300.

According to still another aspect of the present invention, there is provided a ferroelectric material containing constituent elements of Bi, Fe and O wherein when an X-ray diffraction pattern is measured, first and second peaks are observed, the first peak corresponding to (101) and (011) planes and the second peak corresponding to (110) plane being separated from the first peak.

According to still another aspect of the present invention, there is provided a method of manufacturing a ferroelectric film comprising steps of: (a) coating BiFeO₃ precursor solution on a surface of an underlying member; (b) performing heat treatment after the coating to form a dielectric film; and (c) heating the dielectric film in a non-oxidizing atmosphere to crystallize the dielectric film.

According to still another aspect of the present invention, there is provided a ferroelectric memory using the above-described ferroelectric material.

As a crystal lattice of the BFO-containing ferroelectric material containing Bi, Fe and O as constituent elements is changed from a conventional rhombohedral system to the tetragonal or orthorhombic system, large remanent polarization can be obtained. Although the remanent polarization of single crystal BiFeO₃ of the rhombohederal system is 6.1 µC/cm², remanent polarization larger than this can be obtained by changing the lattice structure to the tetragonal or orthorhombic system.

A relative dielectric constant of 300 or smaller is smaller than a relative dielectric constant of PZT, which is about 800. Ferroelectric material having a small relative dielectric constant is suitable for the ferroelectric film material of a one-transistor type FRAM. When an X-ray diffraction pattern of a crystal lattice of the tetragonal system is measured, first and second peaks are observed, the first peak corresponding to (101) and (011) planes and the second peak corresponding to (110) plane being separated from the first peak. Even in the orthorhombic system, the peak corresponding to the (101) plane is generally superposed upon the peak corresponding to the (011) plane if a difference between a-axis and b-axis lengths is small.

As BiFeO₃ of the rhombohedral system is subjected to heat treatment in a non-oxidizing atmosphere, oxygen is partially eliminated and oxygen detects are formed. As the oxygen defects are introduced, the crystal lattice changes to the tetragonal or orthorhombic system.

Reference will now be made, by way of example, to the accompanying drawings in which:
Fig. 1 is a cross sectional view of a capacitor made of BiFeO-containing ferroelectric material according to an embodiment.
Fig. 2 is a graph showing an X-ray diffraction pattern of BiFeO-containing ferroelectric material.
Fig. 3 is a graph showing a P-E hysteresis loop of BiFeO-containing ferroelectric material according to the embodiment.
Fig. 4 is a graph showing the frequency dependency of the relative dielectric constant and dielectric loss angle δ of BiFeO-containing ferroelectric material and BiFeO-containing ferroelectric material which contains La.
Fig. 5 is a graph showing the frequency dependency of the relative dielectric constant and dielectric loss angle δ of BiFeO-containing ferroelectric material which contains Nd.
Fig. 6 is a cross sectional view of one-transistor type FRAM.
Figs. 7A to 7C are cross sectional views of one-transistor - one-capacitor type FRAM during and after manufacture.

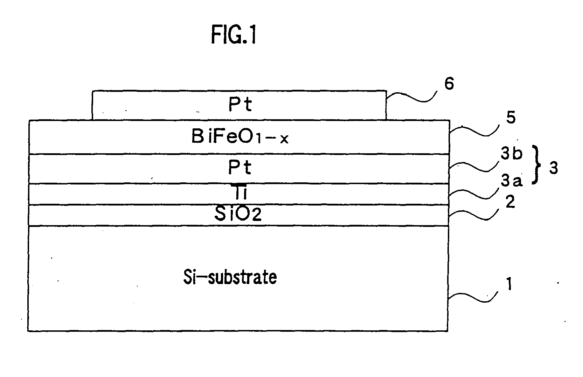

Fig. 1 is a cross sectional view of a capacitor made of ferroelectric material according to an embodiment. On the surface of a substrate 1 made of n-type silicon, a silicon oxide film 2 is formed. For example, the silicon oxide film 2 is formed by thermal oxidation. A lower electrode film 3, a capacitor dielectric film 5 and an upper electrode film 6 are formed in this order on the silicon oxide film 2. The lower electrode film 3 has a two-layer structure of a Ti film 3a having a thickness of 60 nm and a Pt film 3b having a thickness of 100 nm. For example, the Ti film 3a and Pt film 3b can be formed by sputtering.

The capacitor dielectric film 5 is formed, for example, by chemical solution deposition (CSD). This film forming procedure will be described in the following. Precursor solution of BiFeO₃ is spin-coated on the lower electrode 3. For example, solvent for this precursor solution is 2-methoxyethanol, and the concentration of BiFeO₃ is 0.15 mol%. The substrate is placed on a hot plate for one minute at a temperature of 150 °C to evaporate the solvent. After evaporating the solvent, the substrate is placed on a hot plate at a temperature of 400 °C to perform pyrolysis. After the pyrolysis, the substrate is cooled down to room temperature. A BiFeO₃ film is therefore obtained in an amorphous or crystalline state. A series of processes including precursor solution coating, solvent evaporation, pyrolysis and cooling is repeated, for example, 32 times. The number of repetitions is adjusted in accordance with a desired film thickness.

By using a rapid thermal annealing (RTA) system and raising the temperature to 500 °C in 20 seconds in a nitrogen gas atmosphere, heat treatment (crystallization annealing) is performed for 5 minutes. With this heat treatment, BiFeO₃ is crystallized and oxygen is partially eliminated so that oxygen defects (oxygen empty lattice points) occur. BiFeO₃ with oxygen defects is denoted as BiFeO₃₋ₓ. Ferroelectric material which contains Bi, Fe and O as constituent elements, such as BiFeO₃ and BiFeO₃₋ₓ, is called BFO-containing ferroelectric material. A film thickness of BiFeO₃₋ₓ after crystallization is, for example, 300 nm.

On the crystallized capacitor dielectric film 5, the upper electrode film 6 of Pt is formed by vacuum deposition using a metal mask. A capacitor is therefore formed having the capacitor dielectric film 5 made of BFO-containing ferroelectric material with oxygen defects and sandwiched between the lower electrode film 3 and upper electrode film 6.

For comparison, a ferroelectric film was formed which was made of BFO-containing ferroelectric material whose crystallization annealing was performed in an oxidizing atmosphere.

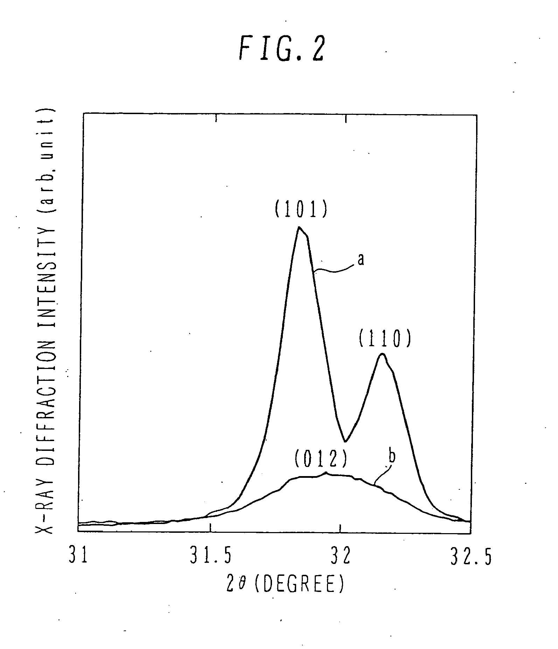

Fig. 2 shows the comparison between an X-ray diffraction pattern (solid line a) of BFO-containing ferroelectric material according to the embodiment and an X-ray diffraction pattern (solid line b) of BFO-containing ferroelectric material according to the comparative example. The BFO-containing ferroelectric material of the comparative example has a broad peak corresponding to the (012) plane, indicating that the material has a crystal lattice of the rhombohedral system.

The BFO-containing ferroelectric material of the embodiment has a relatively high peak corresponding to the (101) plane and a relatively low peak corresponding to the (110) plane. If crystal is of the cubic system, all the (110), (101) and (011) planes are equivalent so that the peaks corresponding to these planes will not be separated. In the BFO-containing ferroelectric material of the embodiment, the peak corresponding to the (101) plane superposes upon the peak corresponding to the (011) plane, and its height is about twice the peak corresponding to the (110) plane. Namely, the crystal lattice of this BFO-containing ferroelectric material can be considered almost the tetragonal system. It can be considered that since BiFeO₃ is annealed in the nitrogen atmosphere, oxygen defects are formed and crystal of almost the tetragonal system is formed.

Crystal of the tetragonal system has the same a-axis and b-axis length of the crystal lattice, and the c-axis length is different from the a-axis length. If the a-axis length is different from the b-axis length, i.e., if crystal is of the orthorhombic system, the peak corresponding to the (101) plane is separated from the peak corresponding to the (011) plane. However, if a difference between the a-axis length and b-axis length is small, the two peaks are not separated clearly, and are observed like one peak. It can therefore be considered from the X-ray diffraction results shown in Fig. 2 that the BFO-containing ferroelectric material of the embodiment is of the tetragonal system or of the orthorhombic system having such a small difference between the a-axis length and b-axis length as unable to be detected through X-ray diffraction.

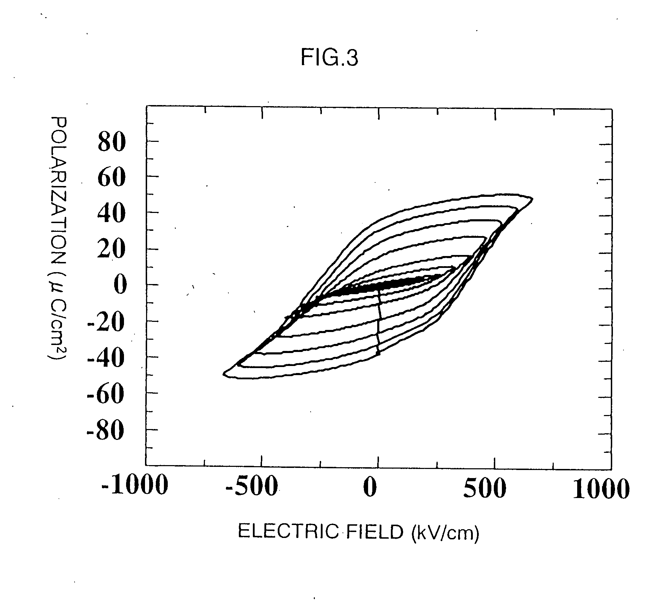

Fig. 3 shows a P-E hysteresis loop of the capacitor dielectric film of the embodiment. The abscissa represents an applied electric field in the unit of "kV/cm" and the ordinate represents the magnitude of polarization in the unit of "µC/cm²". A large hysteresis having a magnitude of remanent polarization of 30 µC/cm² or larger appears. The magnitude of this remanent polarization is about the same degree as that of remanent polarization of PZT. It is known that remanent polarization of single crystal BiFeO₃ of the rhombohedral system is 6.1 µC/cm². If the crystal lattice of BFO-containing ferroelectric material is changed from the rhombohedral system to the tetragonal or orthorhombic system, remanent polarization can be made large.

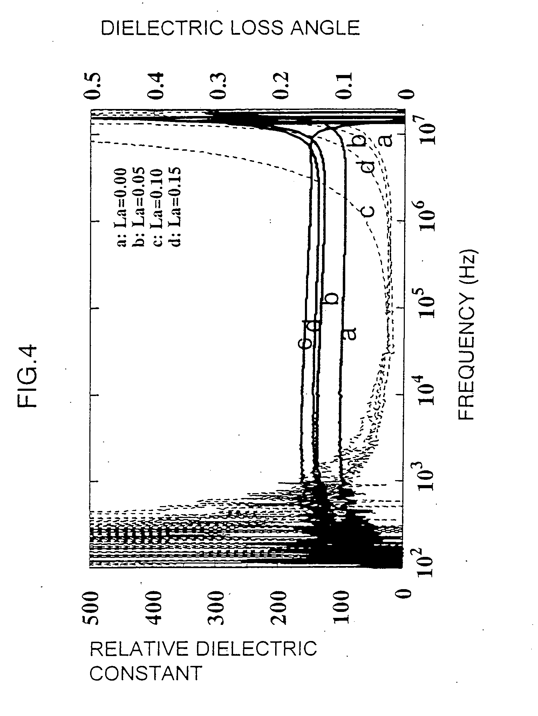

Fig. 4 shows a frequency dependence of a relative dielectric constant and a dielectric loss angle (tan δ) of the BFO-containing ferroelectric material of the embodiment. A solid line a in Fig. 4 indicates the relative dielectric constant, and a broken line a indicates the dielectric loss angle. The abscissa represents a frequency in the unit of "Hz". It can be seen that the relative dielectric constant is about 100 in the frequency range from 1 kHz to 10 MHz. The relative dielectric constant of single crystal BiFeO₃ of the rhombohedral system is about 45 at a frequency of 10 kHz. It can be understood from these results that the BFO-containing ferroelectric material of the embodiment is apparently distinguished from BiFeO₃ of the rhombohedral system.

With the above-described embodiment method, BFO-containing ferroelectric material can be obtained which has remanent polarization larger than 6.1 µC/cm². Such a large remanent polarization cannot be obtained by conventional BiFeO₃ of the rhombohedral system.

In the above-described embodiment, although crystallization annealing is performed at 500 °C, the crystallization annealing temperature may be set to 400 °C to 650 °C.

Also in the above-described embodiment, although crystallization annealing is performed in the nitrogen atmosphere, it may be performed in other non-oxidizing atmospheres to form oxygen defects.

BiFeO₃₋ₓ formed by the embodiment method has a higher empty lattice defect density of oxygen than that of the rhombohedral system. These defects cause an increase in leak current. In order to suppress an increase in leak current, dopant may be added. By adding, as dopant, a rare earth element, preferably La or Nd, an increase in leak current can be suppressed. As the rare earth element such as La and Nd is added, some Bi elements are replaced with La or Nd. In order to obtain the leak current increase suppressing effects, the parameter y is preferably set as 0.05 ≤ y ≤ 0.2 where the composition ratio of Bi is 1 - y and the composition ratio of La or Nd is y. The dopant is added to the precursor solution.

Fig. 4 shows the relative dielectric constant and dielectric loss angle of Bi_{1-y}La_{y}FeO₃₋ₓ added with La. Solid lines b, c and d indicate the relative dielectric constants at the La composition ratios y of 0.05, 0.10 and 0.15, respectively. Broken lines b, c and d indicate the dielectric loss angles at the La composition ratios y of 0.05, 0.10 and 0.15, respectively.

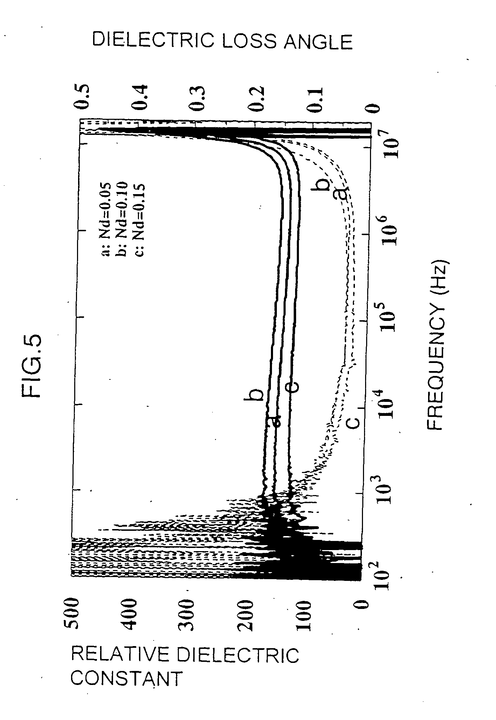

Fig. 5 shows the relative dielectric constant and dielectric loss angle of Bi_{1-y}Nd_{y}FeO₃₋ₓ added with Nd. Solid lines a, b and c indicate the relative dielectric constants at the La composition ratios y of 0.05, 0.10 and 0.15, respectively. Broken lines a, b and c indicate the dielectric loss angles at the Nd composition ratios y of 0.05, 0.10 and 0.15, respectively.

In both cases, a relative dielectric constant of 100 to 200 is obtained in the frequency range from 1 kHz to 10 MHz. A relative dielectric constant of PZT is about 800 and a relative dielectric constant of BLT is about 300. The relative dielectric constant of a ferroelectric film is preferably small in order to apply as large a portion as possible of the gate voltage, across the lamination structure of a gate insulating film and a ferroelectric film of one-transistor type FRAM, to the ferroelectric film. The relative dielectric constants of BiFeO₃₋ₓ doped with La or Nd and undoped BiFeO₃₋ₓ are larger than those of PZT and BLT. Ferroelectric material having a relative dielectric constant of 300 or smaller can be obtained. It can be said that as compared to PZT and BLT, this ferroelectric material is suitable for one-transistor type FRAM.

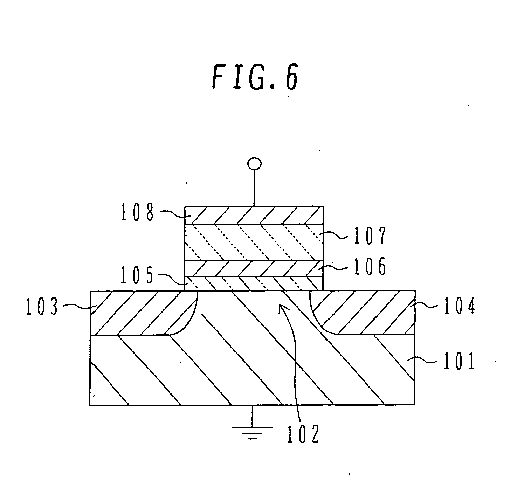

Fig. 6 is a cross sectional view of one-transistor type FRAM according to an embodiment. On the surface of a channel region 102 of a silicon substrate 101, a gate insulating film 105, a floating gate electrode 106, a ferroelectric film 107 and a control gate electrode 108 are laminated in this order. A source region 103 and a drain region 104 are formed in the substrate surface layer on both sides of the channel region 102. The ferroelectric film 107 is made of the BFO-containing ferroelectric material of the tetragonal or orthorhombic system described in the above embodiment.

As a voltage is applied across the silicon substrate 101 and control gate 108, the ferroelectric film 107 is polarized. When the applied voltage is changed to 0 V thereafter, the remanent polarization is left in the ferroelectric film 107. The threshold value of FET changes depending on changes in the magnitude and direction of the remanent polarization. One-bit information can be stored by relating the magnitude of drain current changed with the threshold value to information "0" and "1". In the embodiment shown in Fig. 6, although the floating gate electrode 106 is formed, this may be omitted to form an MFIS-FET structure including the laminated structure of a control gate electrode (M), a ferroelectric film (F), a gate insulating film (I) and a semiconductor substrate (S) formed with a channel region.

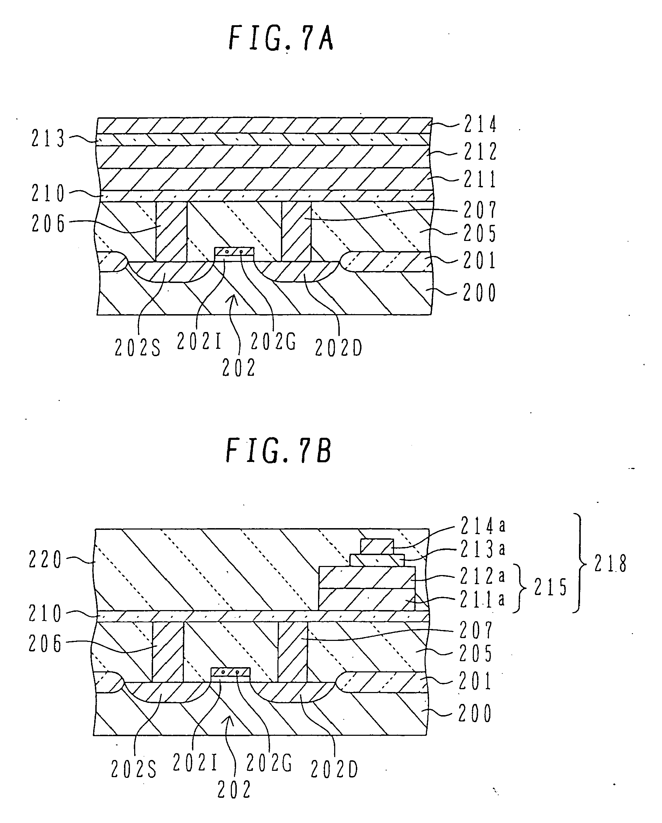

With reference to Figs. 7A to 7C, description will be made of a method of manufacturing one-transistor - one-capacitor type FRAM.

As shown in Fig. 7A, an element isolation insulating film 201 is formed on the surface of a silicon substrate 200 by local oxidation of silicon (LOCOS), shallow trench isolation (STI) or the like. The element isolation insulating film 201 defines active regions. In an active region, a MOSFET (switching element) 202 is formed. MOSFET 202 is constituted of a source region 202S, a drain region 202D, a gate insulating film 202I and a gate electrode 202G.

An interlayer insulating film 205 of silicon oxide is formed covering MOSFET 202. After the surface of the interlayer insulating film 205 is planarized, via holes are formed through the interlayer insulating film 205 at positions corresponding to the source region 202S and drain region 202D. The via holes are filled with conductive plugs 206 and 207 of tungsten or the like. The conductive plugs 206 and 207 are connected to the source region 202S and drain region 202D, respectively.

A protective film 210 of silicon nitride is formed on the interlayer insulating film 205. A Ti film 211 of 60 nm in thickness and a Pt film 212 of 150 nm in thickness are formed in this order by sputtering on the protective film 210. On the Pt film 212, a BFO-containing ferroelectric film 213 of 300 nm in thickness is formed by the embodiment method described with Fig. 1. On the BFO-containing ferroelectric film 213, a Pt film 214 of 100 nm in thickness is formed by electron beam deposition.

As shown in Fig. 7B, the Pt film 214 is patterned to form an upper electrode film 214a of Pt. The BFO-containing ferroelectric film 213 is patterned to form a capacitor dielectric film 213a. The two layers, Pt film 212 and Ti film 211, are patterned to form a lower electrode 215 of the two-layer structure. In this manner, a capacitor 218 is formed being constituted of the lower electrode film 215, capacitor dielectric film 213a and upper electrode film 214a. An interlayer insulating film 220 is formed on the protective film 210, burying the capacitor 210. The surface of the interlayer insulating film is planarized.

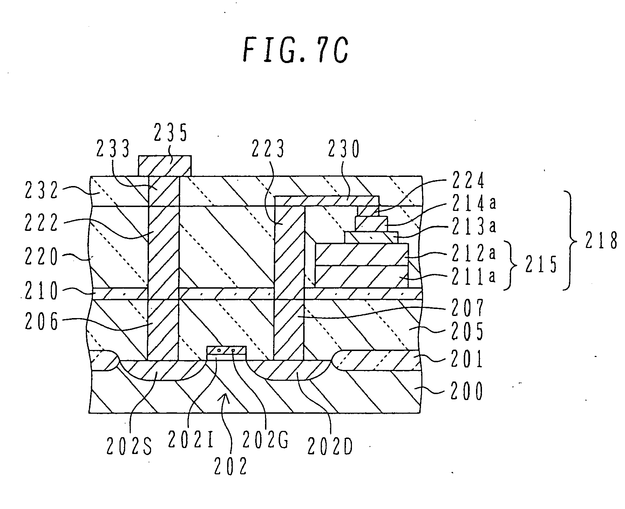

As shown in Fig. 7C, via holes are formed in and through the interlayer insulating film 220 and protective film 210 at predetermined positions, and filled with conductive plugs 222, 223 and 224 of tungsten or the like. The conductive plugs 222 and 223 are connected to the underlying conductive plugs 206 and 207, respectively. The conductive plug 224 is connected to the upper electrode layer 214a.

On the interlayer insulating film 220, an Al wiring 230 is formed interconnecting the conductive plugs 223 and 224. The drain region 202D is therefore connected to the upper electrode layer 214a of the capacitor 218 via the conductive plugs 207 and 223, wiring 230 and conductive plug 224.

An interlayer insulating film 232 of silicon oxide is formed on the interlayer insulating film 220, covering the wiring 230. A via hole is formed through the interlayer insulating film 232 at a predetermined position, and filled with a conductive plug 233 of tungsten. On the interlayer insulating film 232, an Al wiring 235 is formed connected to the conductive plug 233. The source region 202S is therefore connected to the wiring 235 via the conductive plugs 206, 222 and 233.

As the material of a capacitor dielectric film, the BFO-containing ferroelectric material of the tetragonal or orthorhombic system described with Fig. 1 is used, so that a lead-free FRAM can be manufactured. The material of the ferroelectric film of FRAM presents remanent polarization equivalent to that of PZT.

The present invention has been described in connection with the preferred embodiments. The invention is not limited only to the above embodiments. It will be apparent to those skilled in the art that other various modifications, improvements, combinations, and the like can be made.

## Claims

1. A ferroelectric material containing constituent elements of Bi, Fe and O and having crystal lattice of a tetragonal or orthorhombic system.

2. A ferroelectric material containing constituent elements of Bi, Fe and O and having remanent polarization larger than 6.1 µC/cm².

3. A ferroelectric material containing constituent elements of Bi, Fe and O and having a relative dielectric constant equal to or larger than 100 and equal to or smaller than 300.

4. A ferroelectric material containing constituent elements of Bi, Fe and O wherein as an X-ray diffraction pattern is measured, first and second peaks are observed, the first peak corresponding to (101) and (011) planes and the second peak corresponding to (110) plane being separated from the first peak.

5. The ferroelectric material of claim 1, 2, 3, or 4, wherein the ferroelectric material has a composition of BiFeO₃ with oxygen defects.

6. The ferroelectric material of any of claims 1-5, further comprising a rare earth element.

7. The ferroelectric material according to claim 6, wherein y is 0.05 ≤ y ≤ 0.2 where a Bi composition ratio is 1 - y and a rare earth element composition ratio is y.

8. The ferroelectric material according to claim 6 or 7, wherein the rare earth element is La or Nd.

9. A method of manufacturing a ferroelectric film comprising steps of:
(a) coating BiFeO₃ precursor solution on a surface of an underlying member;
(b) performing heat treatment after the coating to form a dielectric film; and
(c) heating the dielectric film in a non-oxidizing atmosphere to crystallize the dielectric film.

10. The method of manufacturing a ferroelectric film according to claim 9, wherein a heating temperature at the step (c) is 400 °C to 650 °C.

11. A ferroelectric memory comprising:
a semiconductor substrate;
source and drain regions formed in a surface layer of the semiconductor substrate and disposed on both sides of a channel region;
a gate insulating film formed on the channel region and including a film made of a ferroelectric material containing constituent elements of Bi, Fe and O and having crystal lattice of a tetragonal or orthorhombic system.

12. A ferroelectric memory comprising:
a switching element formed on a semiconductor substrate for switching a current path between a pair of terminals; and
a capacitor connected to one terminal of the switching element and including a capacitor dielectric film made of a ferroelectric material containing constituent elements of Bi, Fe and O and having crystal lattice of a tetragonal or orthorhombic system.
